# EUROPÄISCHE PATENTSCHRIFT

(11) **EP 0 953 219 B1**
(45) Veröffentlichungstag und Bekanntmachung des Hinweises auf die Patenterteilung: **15.10.2008**
(21) Anmeldenummer: 98955351.6
(22) Anmeldetag: 29.09.1998
(51) Int. Cl.: H01R 13/533, F02M 51/00

(54) **ELEKTRISCHE VERBINDUNGSANORDNUNG**
ELECTRIC CONNECTION CONFIGURATION
DISPOSITIF DE RACCORDEMENT ELECTRIQUE

(30) Priorität: 18.11.1997 DE 19751095
(43) Veröffentlichungstag der Anmeldung: 03.11.1999
(73) Patentinhaber: Continental Automotive GmbH, 30165 Hannover (DE)
(72) Erfinder: LOIBL, Josef, D-94209 Regen (DE)
(86) Internationale Anmeldenummer: PCT/DE1998/002883
(87) Internationale Veröffentlichungsnummer: WO 1999/026319

(56) Entgegenhaltungen:
- EP-A- 0 375 271
- WO-A-92/10011
- WO-A-95/00363
- US-A- 5 040 853
- ABRAMSON E: "IMPROVING HIGH SPEED INTERCONNECTS WITH FLEXIBLE FLUOROPOLYMER LAMINATES" ELECTRONIC PACKAGING AND PRODUCTION, Bd. 31, Nr. 7, 1. Juli 1991, Seiten 60-64, XP000217472

## Beschreibung

Die Erfindung betrifft eine Anordnung zum elektrischen Verbinden einer in einem Gehäuse, insbesondere Getriebegehäuse eines Kraftfahrzeugs, aufgenommenen elektrischen Baugruppe mit einer außerhalb des Gehäuses angeordneten elektrischen Peripherie über ein elektrisches Verbindungselement.

In der Kraftfahrzeugtechnik müssen häufig elektrische Verbindungen zu Bauteilen hergestellt werden, die in einem abgedichteten Gehäuse aufgenommen sind. Beispielsweise müssen bei elektronisch gesteuerten Automatikgetrieben von Personenkraftwagen die im Getriebegehäuse vorhandene Sensorik sowie die dort vorhandenen mechanischen Betätigungselemente mit einer außerhalb des Getriebegehäuses angeordneten elektrischen Peripherie in Verbindung stehen. Dies macht es erforderlich, Spannungsversorgungsleitungen - und bei einem außerhalb des Getriebegehäuses angeordneten Getriebesteuergerät auch Steuersignalleitungen - durch die Getriebewand in den Getriebeinnenraum zu führen. Hierfür werden spezielle Getriebestecker verwendet, die in Bohrungen der Getriebewand eingesetzt sind. Diese Stecker sind verhältnismäßig aufwendig gestaltet, da sowohl die Verbindung zwischen Bohrung und Steckeraußenseite als auch die im Stecker integrierten Kontaktstifteinpassungen öldicht ausgeführt sein müssen.

Seit einiger Zeit besteht die Tendenz, die Steuerelektronik für das Automatikgetriebe vermehrt in den Getriebeinnenraum zu verlagern. In diesem Fall ist es nicht mehr erforderlich, die von der Getriebesensorik gelieferten Signale aus dem Getriebeinnenraum heraus zu führen. Auf eine elektrische Durchführung von außen in den Getriebeinnenraum kann jedoch auch bei diesem Konzept nicht verzichtet werden. Bei einer solchen "Vorortelektronik" stellt sich außerdem das Problem, daß die Steuerelektronik zum Schutz gegen die den Getriebeölen zugesetzten höchst aggressiven Additive in einem eigenen Steuergerätgehäuse untergebracht werden muß. Dies macht weitere elektrische Durchführungen erforderlich, die in der Regel in Form von öldichten Steckverbindungen am Steuergerätgehäuse ausgeführt sind.

In der EP 0 513 263 ist eine Kraftstoffeinspritzpumpe beschrieben, bei der elektrische Leiter in Form von auf einer flexiblen Leiterfolie aufgebrachten Leiterbahnen durch einen Dichtspalt zwischen einem Gehäuse und einem Gehäusedeckel in das Gehäuseinnere hinein geführt werden. Diese Schrift betrifft weder ein Getriebegehäuse noch den Fall, daß in dem Gehäuse mehrere elektrische Bauteile vorhanden sind. Darüber hinaus befindet sich die in dieser Schrift beschriebene Steuerelektronik für die Kraftstoffeinspritzpumpe außerhalb des abgedichteten Gehäusebereichs.

Es ist eine Aufgabe der vorliegenden Erfindung, eine einfache und kostengünstige Anordnung zum elektrischen Verbinden einer aus mehreren elektrischen Bauteilen bestehenden Baugruppe innerhalb eines abgedichteten Gehäuses, insbesondere Getriebegehäuses, mit einer außerhalb des Gehäuses vorhandenen elektrischen Peripherie zu schaffen.

Diese Aufgabe wird durch eine Anordnung gemäß den Merkmalen des Anspruchs 1 gelöst.

Durch die Doppelfunktion des elektrischen Verbindungselements, nämlich einerseits die elektrische Verbindung zu der elektrischen Peripherie im Außenbereich des Gehäuses herzustellen und andererseits mehrere im Gehäuse vorhandene Bauteile gemeinsam zu kontaktieren, wird ein sehr kostengünstiger Gesamtaufbau der elektrischen Verbindungsanordnung erzielt. Die dichtspaltseitige Durchführung schafft eine einfache und effektive elektrische Anbindungsmöglichkeit von außen, die ermöglicht, daß der bisher verwendete teure Gehäusestecker entfallen kann. Dabei können die bisher verwendeten Dichtungen beibehalten werden, und aufgrund der Ausbildung des elektrischen Verbindungselementes als flacher Leiterbahnträger müssen keine zusätzlichen Maßnahmen zur Abdichtung ergriffen werden. Darüber hinaus wird die im Getriebegehäuse vorhandene Leitungsführung zu den einzelnen elektrischen Bauteilen wesentlich vereinfacht, da mehrere der elektrischen Bauteile an ein und demselben elektrischen Verbindungselement - an jeweils zu dem Bauteil hingeführten Endabschnitten desselben - mit den dort vorgesehenen Leiterbahnen kontaktiert sind. Somit lassen sich durch den Einsatz des erfindungsgemäßen, als Leiterbahnträger mit Leiterbahnen ausgeführten elektrischen Verbindungselementes die bei der elektrischen Durchführung in das Gehäuse erzielten Vorteile mit Vorteilen bei der Leitungsführung innerhalb des Gehäuses kombinieren.

Nach einem besonders bevorzugten Ausführungsbeispiel der vorliegenden Erfindung ist eines der elektrischen Bauteile ein Steuergerät, das andere der im Gehäuse enthaltenen elektrischen Bauteile steuert. In diesem Fall sind gehäuseinterne elektrische Verbindungen zwischen dem Steuergerät und den gesteuerten Bauteilen erforderlich. Dabei wird durch die erfindungsgemäß vorgesehene gemeinsame Anbindung der elektrischen Bauteile und des Steuergerätes an das elektrische Verbindungselement erreicht, daß sowohl die elektrischen Zuleitungen von außen als auch die angesprochenen Zwischenverbindungen in ein und demselben Leiterbahnträger aufgenommen sind. Neben dem Aspekt der vergleichsweise geringen Herstellungskosten eines solchen elektrischen Verbindungselementes werden aufgrund des einfachen Zusammenbaus auch die bei der Montage anfallenden Kosten gesenkt.

Vorzugsweise besteht das Steuergerät aus wenigstens zwei öldicht miteinander verbundenen Steuergerät-Gehäuseteilen, wobei das elektrische Verbindungselement zwischen den Steuergerät-Gehäuseteilen in das Steuergerät hinein geführt ist. Dadurch entfällt die Notwendigkeit der Verwendung eines durchkontaktierenden Gehäusesteckers am Steuergerätgehäuse.

Das elektrische Verbindungselement weist vorzugsweise einen im Steuergerät aufgenommenen Zentralabschnitt auf, welcher mit Bauteil-Fortsätzen versehen ist, die zwischen den Steuergerät-Gehäuseteilen aus dem Steuergerät herausgeführt sind und an ihren Endabschnitten die elektrischen Bauteile kontaktieren. Ein solcher gewissermaßen sternförmiger Aufbau des elektrischen Verbindungselements ermöglicht eine besonders wirksame Entflechtung der Leitungsführung zu den einzelnen elektrischen Bauteilen, wie sie bei Verwendung eines gemeinsamen Gehäusesteckers mit jeweils separater Zuleitungsverkabelung nicht realisierbar ist.

Nach einer vorteilhaften Ausgestaltung der Erfindung besteht der Leiterbahnträger aus einer flexiblen Leiterbahnfolie, die aus einer Basisfolie und einer Deckfolie aufgebaut ist, wobei die Leiterbahnen zwischen der Basisfolie und der Deckfolie eingebettet sind. Dadurch wird eine sichere elektrische Isolierung der Leiterbahnen nach außen, insbesondere auch in den Bereichen der Gehäusedurchführungen, erreicht.

Durch das Vorsehen einer Klebung zwischen dem Leiterbahnträger und dem Getriebe- und/oder Steuergerät-Gehäuseteil im Durchführungsbereich läßt sich die Dichtwirkung weiter erhöhen und die Lagestabilität des elektrischen Verbindungselementes sowie die Positionierbarkeit desselben beim Zusammenbau verbessern.

Weitere bevorzugte Ausgestaltungen der Erfindung sind in den Unteransprüchen angegeben.

Die Erfindung wird nachfolgend anhand eines Ausführungsbeispiels in Verbindung mit der Zeichnung beschrieben. In dieser zeigt:
- Fig. 1: eine schematische Querschnittansicht eines automatischen Schaltgetriebes mit einem in der Ölwanne aufgenommenen Getriebesteuergerät;
- Fig. 2: eine schematische Darstellung einer elektrischen Verbindungsanordnung in Draufsicht;
- Fig. 3: eine Schnittansicht durch einen Leiterbahnträger in Richtung einer darin verlaufenden elektrischen Leiterbahn; und
- Fig. 4: das Gehäuse eines Getriebesteuergerätes mit einer im Dichtungsbereich eintretenden elektrischen Verbindungsanordnung.

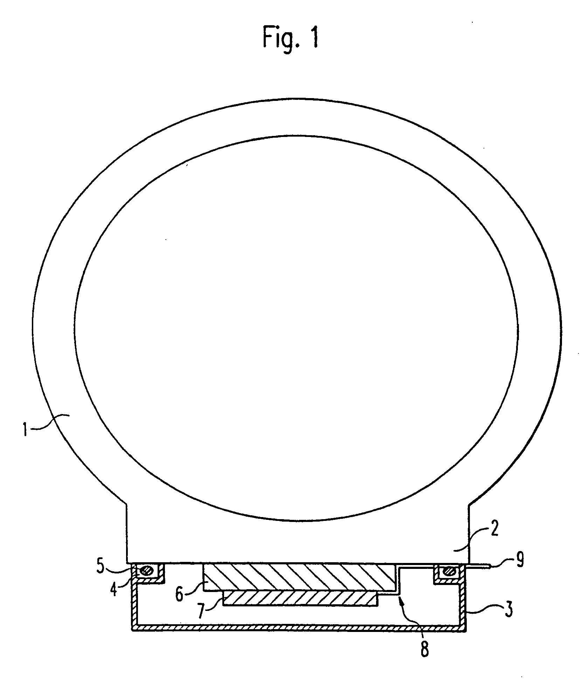

Nach Figur 1 weist ein elektrisch gesteuertes Automatikgetriebe ein Getriebegehäuse 1 auf, das in seinem unteren Bereich mit einem Dichtflansch 2 versehen ist, an den eine Ölwanne 3 angeflanscht ist. Die Ölwanne 3 weist in ihrer flanschseitigen Dichtfläche eine umlaufende Nut 4 auf, in der eine Getriebedichtung 5 eingesetzt ist. Die Getriebedichtung 5 kann beispielsweise auf Acrylat-Basis ausgeführt sein.

Im Inneren der Ölwanne 3 erstreckt sich eine hydraulische Schaltplatte 6, die mit dem in Figur 1 nicht dargestellten Automatikgetriebe in mechanischer Verbindung steht und an deren Unterseite ein elektrisches Getriebesteuergerät 7 angeordnet ist. An das Getriebesteuergerät 7 ist ein elektrisches Verbindungselement 8 angeschlossen, das mit einem Fortsatz 9 zwischen dem Dichtflansch 2 und der Getriebedichtung 5 in den Außenbereich des Getriebegehäuses 1 geführt ist.

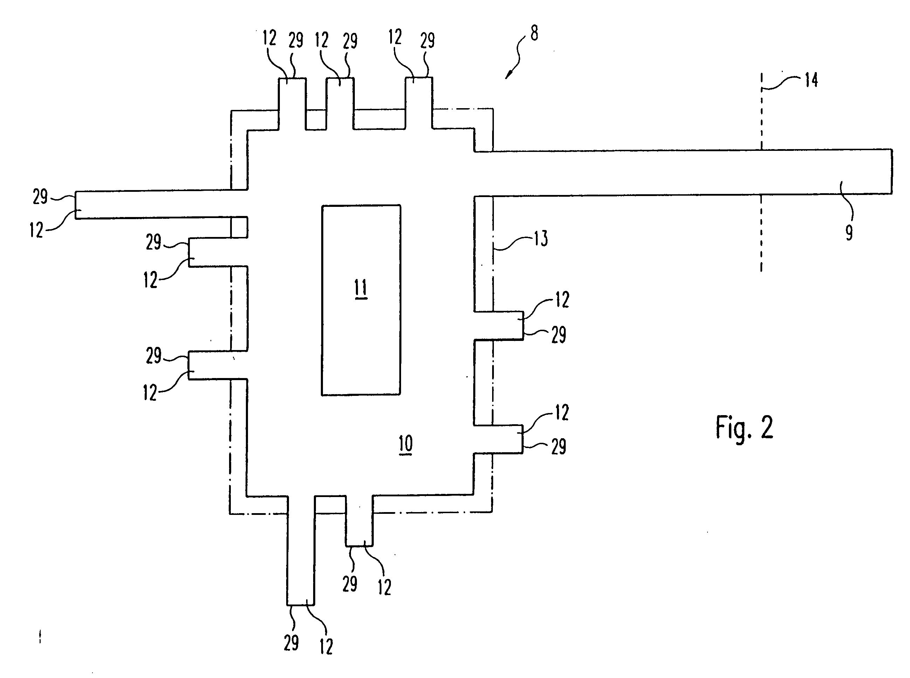

Figur 2 zeigt eine schematische Darstellung des in Figur 1 verwendeten elektrischen Verbindungselements 8 in Draufsicht und dient der Erläuterung der Formgebung desselben. Die einzelnen Leiterbahnwege sind in der Darstellung nicht erkennbar. Das elektrische Verbindungselement 8 weist einen im Grundriß rechteckigen Zentralbereich 10 auf, in dessen Mitte eine Aussparung 11 vorgesehen ist. Von dem Zentralbereich 10 führen nach außen verlaufende Bauteil-Fortsätze 12 mit Endabschnitten 29 weg, die zur Kontaktierung des elektrischen Verbindungselements 8 mit einzelnen Aktuatoren und Sensoren im Getriebegehäuse vorgesehen sind. Die Länge und Formgebung der Bauteil-Fortsätze 12 richtet sich nach der Einbaulage des Steuergerätes sowie der Orte der zu kontaktierenden elektrischen Bauteile. Der Zentralbereich 10 steht ferner mit dem nach außen führenden Fortsatz 9 in Verbindung.

Im eingebauten Zustand ist der Zentralbereich 10 vollständig im Gehäuse des Getriebesteuergerätes 7 aufgenommen. Die strichpunktierte Linie 13 gibt den Verlauf des Gehäusedichtspaltes wieder, durch den die Fortsätze 9 und 12 aus dem Gehäuse herausgeführt sind. Die gestrichelte Linie 14 deutet eine Stelle an, an der der Fortsatz 9 den Getriebeinnenraum verläßt.

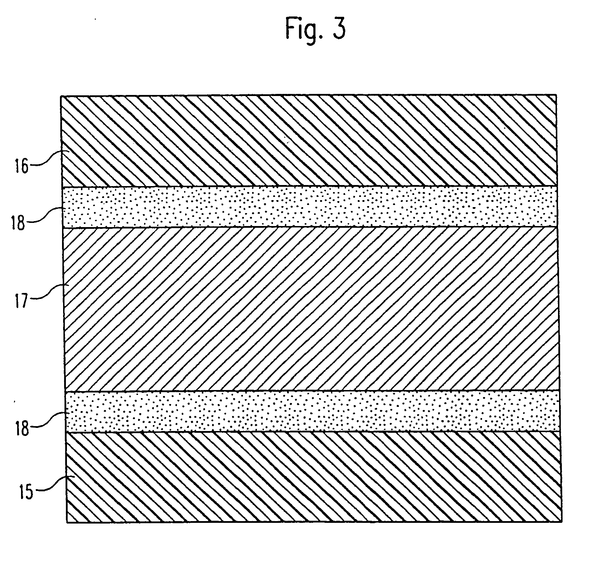

In Fig. 3 ist der Aufbau des elektrischen Verbindungselementes 8 im Längsschnitt bezüglich des Verlaufes einer Leiterbahn gezeigt. Eine untere Basisfolie 15 und eine obere Deckfolie 16 bestehen aus Polyimid und umgeben eine Leiterbahn 17, die in einer Kleberschicht 18 eingebettet ist. Dieser Aufbau bewirkt, daß die Leiterbahnen 17 untereinander und nach außen elektrisch isoliert in dem elektrischen Verbindungselement 8 geführt sind. Basisfolie 15 und Deckfolie 16 bilden einen Leiterbahnträger.

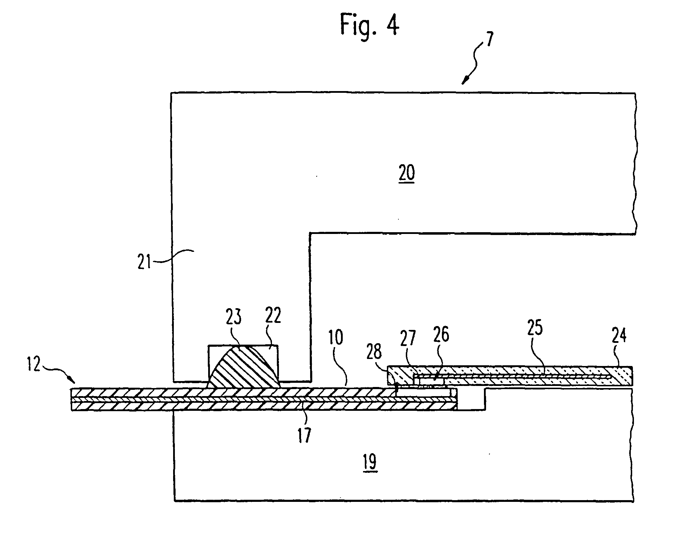

Figur 4 zeigt die Durchführung eines gemäß Fig. 3 aufgebauten Bauteil-Fortsatzes 12 durch das Gehäuse des Getriebesteuergerätes 7. Das Gehäuse besteht aus einer metallischen Grundplatte 19 und einem Gehäuseaufsatz 20, an dem eine umlaufende Gehäusewand 21 ausgebildet ist. Der Bauteil-Fortsatz 12 durchläuft einen Dichtspalt zwischen der Gehäusewand 21 und der Grundplatte 19 und ist in diesem Bereich mit einem ölbeständigen Kleber auf die Grundplatte aufgeklebt. Im Stirnbereich der Gehäusewand 21 befindet sich eine umlaufende Dichtnut 22, in die ein ölbeständiger Dichtring 23 eingreift. Der Dichtring 23 kann auf den Bauteil-Fortsatz 12 aufgedrückt oder anvulkanisiert sein und dichtet den Bauteil-Fortsatz 12 gegenüber der Gehäusewand 21 ab. Die Dichtnut 22 und der Dichtring 23 sind optional, d.h. die grundplattenseitige Stirnfläche der Gehäusewand 21 kann auch als ebene Dichtfläche ausgebildet sein, wobei in diesem Fall die Abdichtung allein durch eine auf den Leiterbahnträger 15, 16 ausgeübten, hinreichenden Anpreßdruck herbeigeführt wird. Ferner kann eine Abdichtung auch durch den Einsatz zusätzlicher Dichtelemente bewirkt oder verbessert werden und es ist ebenfalls möglich, daß der Zentralbereich 10 des elektrischen Verbindungselementes 8 den Dichtbereich des Getriebesteuergerätgehäuses allseitig überspannt und damit zu dessen Abdichtung beiträgt.

Ferner ist in Figur 4 ein als Schaltungsträger dienendes Keramiksubstrat (LTCC) 24 mit Leiterbahnen 25 dargestellt. Die Leiterbahnen 25 des Keramiksubstrats 24 sind mit den Leiterbahnen 17 des elektrischen Verbindungselements 8 über Kontaktstellen 26 elektrisch verbunden, die mittels eines elektrisch leitenden Kontaktklebers 27 an einem freiliegenden Kontaktpad 28 über einer Leiterbahn 17 gebildet sind.

Die Durchführung des Fortsatzes 9 zwischen den Getriebegehäuseteilen erfolgt in analoger Weise, wie dies in der Fig. 4 in bezug auf den Bauteil-Fortsatz 12 und die Gehäuseteile 19, 21 des Steuergerätes 7 beschrieben wurde. Auch hier kann die Dichtigkeit durch eine öldichte Klebung des Fortsatzes 9 an den Getriebegehäuseflansch 2 verbessert werden und es kann bei Bedarf ebenfalls der Einsatz von weiteren Dichtelementen neben der bereits angesprochenen Gehäusedichtung 5 (siehe Fig. 1) vorgesehen sein.

## Patentansprüche

1. Anordnung zum elektrischen Verbinden einer in einem Gehäuse, insbesondere Getriebegehäuse eines Kraftfahrzeugs, aufgenommen, aus mehreren elektrischen Bauteilen bestehenden elektrischen Baugruppe mit einer außerhalb des Gehäuses angeordneten elektrischen Peripherie über ein elektrisches Verbindungselement (8), wobei
das Gehäuse aus wenigstens zwei Gehäuseteilen (1, 3) besteht, die über eine Gehäusedichtung (5) dicht miteinander gekoppelt sind und
das elektrische Verbindungselement (8) als ein flacher, aus einem elektrisch isolierenden material aufgebauter, flexibler Leiterbahnträger (15, 16) mit darin integrierten elektrischen Leiterbahnen (12) ausgebildet ist,
im Bereich der Gehäusedichtung (5) zwischen den beiden Gehäuseteilen (1, 3) hindurch geführt ist, und
zu den einzelnen Bauteilen hinführende Endabschnitte (29) aufweist, an denen die Bauteile über dort vorhandene Leiterbahnen (17) elektrisch kontaktiert sind, derart, dass mehrere der Bauteile durch die Leiterbahnen (17) untereinander verbunden sind.

2. Anordnung nach Anspruch 1,
**dadurch gekennzeichnet, daß**
eines der elektrischen Bauteile ein Steuergerät (7) ist, das andere der im Gehäuse
(1, 3) enthaltenen Bauteile steuert.

3. Anordnung nach Anspruch 2,
**dadurch gekennzeichnet, daß**,
das Steuergerät (7) ein aus wenigstens zwei öldicht miteinander verbundenen Gehäuseteilen (19, 20) aufgebautes Steuergerät-Gehäuse aufweist, und
das elektrische Verbindungselement (8) zwischen den Gehäuseteilen (19, 20) des Steuergerätes (7) in das Steuergerät (7) hinein geführt ist

4. Anordnung nach Anspruch 3,
**dadurch gekennzeichnet, daß**
das elektrische Verbindungselement (8) einen im Steuergerät (7) aufgenommenen Zentralabschnitt (10) aufweist, welcher mit Bauteil-Fortsätzen (12) versehen ist, die zwischen den Steuergerät-Gehäuseteilen aus dem Steuergerät heraus geführt sind und an ihren Endabschnitten (29) jeweils die elektrischen Bauteile kontaktieren.

5. Anordnung nach Anspruch 4,
**dadurch gekennzeichnet, daß**
der Zentralabschnitt (10) des elektrischen Verbindungselements (8) eine Aussparung (11) aufweist und
in der Aussparung (11) ein Schaltungsträger (24) vorgesehen ist, der über dort vorhandene Leiterbahnen (17) des Verbindungselements (8) kontaktiert ist.

6. Anordnung nach einem der vorhergehenden Ansprüche,
**dadurch gekennzeichnet, daß**
der Fortsatz (9) des elektrischen Verbindungselements (8) im Bereich der Durchführung durch das Gehäuse mit wenigstens einem der Gehäuseteile (1, 3) öldicht verklebt ist.

7. Anordnung nach einem der Ansprüche 3 bis 6,
**dadurch gekennzeichnet, daß**
die Bauteil-Fortsätze (12) des elektrischen Verbindungselements (8) in den Bereichen der Durchführungen durch das Gehäuse des Steuergerätes (7) mit wenigstens einem der Gehäuseteile (19, 20) öldicht verklebt sind.

8. Anordnung nach einem der vorhergehenden Ansprüche,
**dadurch gekennzeichnet, daß**
der Leiterbahnträger aus einer flexiblen Leiterbahnfolie besteht,
die Leiterbahnfolie aus einer Basisfolie (15) und einer Deckfolie (16) aufgebaut ist, und die Leiterbahnen (17) zwischen der Basisfolie (15) und der Deckfolie (16) eingebettet sind.

## Claims

1. Arrangement for the electrical connection of an electrical module consisting of several electrical components and accommodated in a housing, in particular gearbox housing of a motor vehicle, said module having an electrical periphery arranged outside the housing by way of an electrical connecting element (8), with
the housing consisting of at least two housing parts (1, 3) which are closely coupled to one another by way of a housing seal (5) and
the electrical connecting element being embodied as a flat flexible conductor carrier (15, 16) assembled from an electrically insulating material and having electrical conductors (12) integrated therein,
being guided through between the two housing parts (1, 3) in the region of the housing seal (5) and
having end sections (29) which guide through toward the individual components, on which end sections the components are electrically contacted by way of conductors (17) present there, such that several of the components are connected to one another by way of the conductors (17).

2. Arrangement according to claim 1, **characterised in that** one of the electrical components is a control device (7), which controls other components contained in the housing (1, 3).

3. Arrangement according to claim 2, **characterised in that** the control device (7) has a control device housing assembled from at least two housing parts (19, 20) which are connected to one another in an oil-tight fashion and
the electrical connecting element (8) is guided into the control device (7) between the housing parts (19, 20) of the control device (7).

4. Arrangement according to claim 3,
**characterised in that**
the electrical connecting element (8) has a central section (10) accommodated in the control device (7), which is provided with component appendages (12), which are guided out of the control device between the control device housing parts and contact the electrical components at their end sections (29) in each instance.

5. Arrangement according to claim 4,
**characterised in that**
the central section (10) of the electrical connecting element (8) has a recess (11) and a circuit carrier (24) is provided in the recess (11), which is contacted by way of conductors (17) of the connecting element (8) which are present there.

6. Arrangement according to one of the preceding claims, **characterised in that** the appendage (9) of the electrical connecting element (8) adheres to at least one of the housing parts (1, 3) so as to form an oil-tight seal in the region of the housing feed-through.

7. Arrangement according to one of claims 3 to 6, **characterised in that** the component appendage (12) of the electrical connecting element (8) adheres to at least one of the housing parts (19, 20) so as to form an oil-tight seal in the regions of the feed-throughs through the housing of the control device (7).

8. Arrangement according to one of the preceding claims,
**characterised in that**
The conductor support consists of a flexible conductor foil, the conductor foil being configured from a basic foil (15) and a cover foil (16) and the conductors (17) being embedded between the basic foil (15) and the cover foil (16).

## Revendications

1. Agencement pour connecter électriquement un module électrique composé de plusieurs composants électriques et logé dans un carter, en particulier dans un carter de boîte de vitesses d'un véhicule automobile, à un équipement périphérique électrique disposé à l'extérieur du carter, au moyen d'un élément de connexion électrique (8), dans lequel le carter est composé d'au moins deux parties de carter (1, 3) qui sont accouplées l'une à l'autre à joint étanche au moyen d'une garniture d'étanchéité de carter (5), et l'élément de connexion électrique (8) est réalisé sous forme d'un support de pistes conductrices (15, 16) platet flexible, fait d'une matière électriquement isolante et possédant des pistes conductrices électriques (12) qui y sont intégrées, cet élément est enfilé entre les deux parties du carter (1, 3), dans la région de la garniture d'étanchéité de carter (5), et il présente des segments terminaux (29) menant aux différents composants, et avec lesquels les composants sont mis en contact électrique au moyen de pistes conductrices (17) présentes à cet endroit, de sorte que plusieurs des composants sont connectés entre eux par les pistes conductrices (17).

2. Agencement selon la revendication 1, **caractérisé en ce qu'**un des composants électriques est un appareil de commande (7) qui commande d'autres composants contenus dans le carter (1, 3).

3. Agencement selon la revendication 2, **caractérisé en ce que** l'appareil de commande (7) présente un carter d'appareil de commande composé d'au moins deux parties de carter (19, 20) assemblées l'une à l'autre à joint étanche à l'huile, et l'élément de connexion électrique (8) est engagé dans l'appareil de commande (7) en passant entre les parties de carter (19, 20) de l'appareil de commande (7).

4. Agencement selon la revendication 3,**caractérisé en ce que** l'élément de connexion électrique (8) présente un segment central (10) logé dans l'appareil de commande (7) et muni de prolongements pour composants (12) qui émergent de l'appareil de commande en passant entre les parties de carter de l'appareil de commande et qui entrent respectivement en contact avec les composants électriques au niveau de leurs segments terminaux (29).

5. Agencement selon la revendication 4,**caractérisé en ce que** le segment central (10) de l'élément de connexion électrique (8) présente un évidement (11) et,
dans l'évidement (11) est prévu un support de circuit (24) avec lequel le contact est établi par l'intermédiaire de pistes conductrices (17) de l'élément de connexion (8) qui sont présentes à cet endroit.

6. Agencement selon une des revendications précédentes, **caractérisé en ce que** le prolongement (9) de l'élément de connexion électrique (8) est collé à joint étanche à l'huile à au moins une des parties de carter (1, 3) dans la région du passage à travers le carter.

7. Agencement selon une des revendications 3 à 6, **caractérisé en ce que**
les prolongements pour composants (12) de l'élément de connexion électrique (8) sont collés à joint étanche à l'huile à au moins une des parties de carter (19, 20) dans les régions des passages à travers le carter de l'appareil de commande (7).

8. Agencement selon une des revendications précédentes, **caractérisé en ce que** le support de pistes conductrices est composé d'un film de pistes conductrices souple, le film de pistes conductrices est composé d'un film de base (15) et d'un film de revêtement (16), et les pistes conductrices (17) sont inclus entre le film de base (15) et le film de revêtement (16).
